# EUROPEAN PATENT APPLICATION

(11) **EP 0 848 317 A2**
(43) Date of publication of application: **17.06.1998**
(21) Application number: 97401711.3
(22) Date of filing: 16.07.1997
(51) Int. Cl.: G06F 1/03

(54) **Signal generating device and electronic device using the same**

(30) Priority: 13.12.1996 JP 334272/96
(71) Applicant: FUJITSU LIMITED, Kawasaki-shi, Kanagawa 211-8588 (JP)
(72) Inventor: Komura, Tatsuki, c/o Fujitsu Limited, Kawasaki-shi, Kanagawa 211 (JP)
(74) Representative: Joly, Jean-Jacques

(57) **Abstract**

The signal generating device includes a first part (150) which generates a given signal when an operation control signal applied thereto becomes active, and a second part (200) which causes the first part to continue to generate the given signal until the given signal becomes equal to a given level after the operation control signal becomes inactive.

## Description

### BACKGROUND OF THE INVENTION

### 1. Field of the Invention

The present invention generally relates to a signal generating device generating a signal having a certain frequency component, and more particularly to a signal generating device having a D/A converter, such as a tone signal generating device generating a tone signal having a given frequency. Further, the present invention is concerned with an electronic device having such a signal generating device.

Conventionally, various types of electronic devices are equipped with a signal generating device which generates a signal having a given frequency. For example, a telephone set is equipped with a tone signal generating device which generates a tone signal. Recent signal generating devices employ a D/A converter. The present invention relates to a signal generating device equipped with a D/A converter, such as a tone signal generating device as described above.

### 2. Description of the Related Art

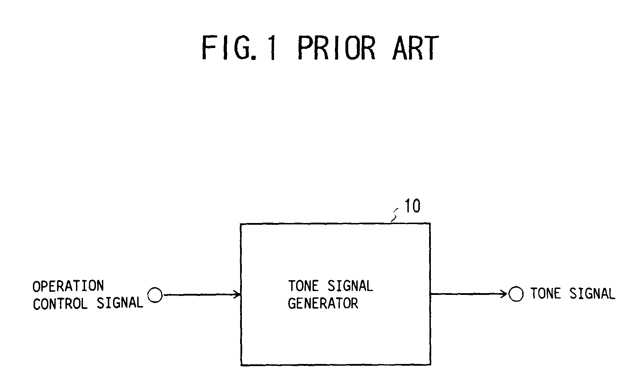

Fig. 1 is a block diagram of a conventional tone signal generating device 10 equipped with a built-in D/A converter. The tone signal generating device 10 is provided in an electronic device such as a telephone set, and generates a tone signal during an operation period indicated by an operation control signal supplied from an external circuit or device (for example, a CPU or a microcomputer provided in the telephone set). The operation control signal is generated when the telephone set receives a call, the driving capability of a battery becomes lower than a given level, or a predetermined push button is pushed.

An internal circuit of the tone signal generating device counts a given clock signal (which is, for example, an operation clock signal of the CPU) during the period when the operation control signal is continuously applied, and thus generates a given timing signal. A digital value corresponding to the given timing signal is read from a memory, and is converted into an analog signal, which is a tone signal.

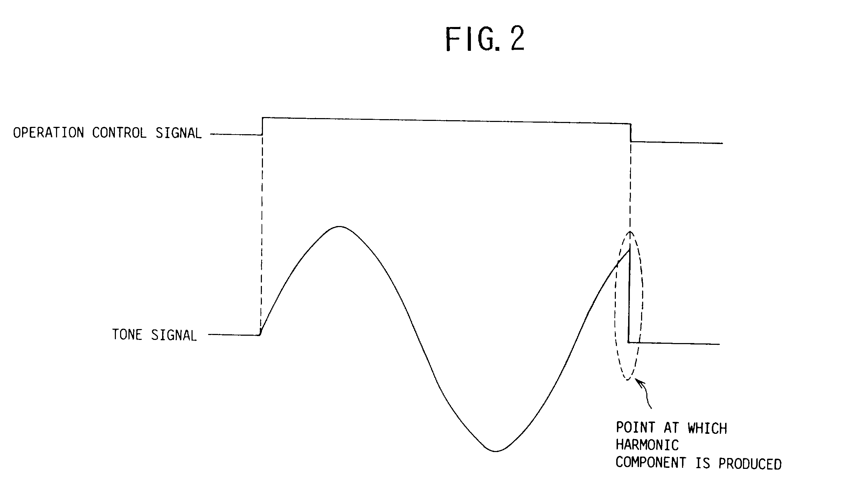

However, the conventional signal generating circuits equipped with the D/A converter as described above have a disadvantage, which will now be described with reference to Fig. 2.

As shown in Fig. 2, the tone signal generating device 10 generates the tone signal during the period when it continues to receive the operation control signal. When the tone signal is turned OFF (made inactive) in a state in which the voltage level of the tone signal is located around the center of a sine wave (which approximately corresponds to a voltage level obtained when the tone signal is not generated), a noise caused by a harmonic component of the tone signal does not occur. Hence, the operator who handles the electronic device does not feel uncomfortable, and another device connected to the electronic device is not affected by the nose.

However, as shown in Fig. 2, if the tone signal is turned OFF in a state in which the level of the tone signal is away from the center thereof, the tone signal generating device 10 stops generating the tone signal. Hence, an abrupt change in the voltage level of the tone signal occurs, and thus causes a harmonic component to be included in the tone signal. Such a harmonic signal is a noise, which makes the operator feel uncomfortable and may affect a peripheral device.

In short, the tone signal generating device has the disadvantage caused by a random control which immediately stops generating the tone signal when the operation control signal is turned OFF.

### SUMMARY OF THE INVENTION

It is a general object of the present invention to provide a signal generating device and an electronic device equipped with such a signal control device in which the above disadvantage is eliminated.

A more specific object of the present invention is to provide a signal generating device capable of generating a given signal with less noise even under random control and provide an electronic device equipped with such a signal generating device.

The above objects of the present invention are achieved by a signal generating device comprising: a first part which generates a given signal when an operation control signal applied thereto becomes active; and a second part which causes the first part to continue to generate the given signal until the given signal becomes equal to a given level after the operation control signal becomes inactive.

The above objects of the present invention are also achieved by a signal generating device comprising: a signal processing part which generates a quantizing signal using a clock signal; a D/A converter which converts the quantizing signal into an analog signal; and a control part which controls the signal processing part to generate the quantizing signal when an operation control signal externally supplied is activated and to continue to generate the quantizing signal until the analog signal output by the D/A converter becomes equal to a given level after the operation control signal is made inactive.

The signal generating device may be configured so that the control part comprises a coincidence detection part which compares the quantizing signal with a given detecting condition value and makes a decision as to whether the analog signal becomes equal to the given level.

The signal generating device may be configured so that the signal processing part comprises: a timing generator which counts the clock signal and thus produces a data control signal; and a D/A input value generator which generates the quantizing signal based on the data control signal, and so that the control part comprises a coincidence detection part which compares the quantizing signal with a given detecting condition value and makes a decision as to whether the analog signal becomes equal to the given level.

The signal generating device may be configured so that the control part comprises a coincidence detection part which compares the analog signal with a given detecting condition value and makes a decision as to whether the analog signal becomes equal to the given level.

The signal generating device may be configured so that the analog signal comprises a single frequency component.

The signal generating device may be configured so that the analog signal comprises a plurality of frequency components.

The signal generating device may be configured so that the control part comprises a programmable part which stores the detecting condition value in a programmable formation.

The above objects of the present invention are also achieved by an electronic device comprising: a speaker which outputs an acoustic signal corresponding to a tone signal; a part which generates an operation control signal; and a signal generating device generating the tone signal, the signal generating device comprising: a first part which generates the tone signal when the operation control signal applied thereto becomes active; and a second part which causes the first part to continue to generate the tone signal until the tone signal becomes equal to a given level after the operation control signal becomes inactive.

The above objects of the present invention are also achieved by an electronic device comprising: a speaker which outputs an acoustic signal corresponding to a tone signal; a part which generates an operation control signal; and a signal generating device generating the tone signal, the signal generating device comprising: a signal processing part which generates a quantizing signal using a clock signal; a D/A converter which converts the quantizing signal into an analog signal which is the tone signal; and a control part which controls the signal processing part to generate the quantizing signal when the operation control signal is activated and to continue to generate the quantizing signal until the analog signal output by the D/A converter becomes equal to a given level after the operation control signal is made inactive.

### BRIEF DESCRIPTION OF THE DRAWINGS

Other objects, features and advantages of the present invention will become more apparent from the following detailed description when read in conjunction with the accompanying drawings, in which:
Fig. 1 is a block diagram of a conventional tone signal generating device;
Fig. 2 is a waveform diagram showing an operation of the tone signal generating device;
Fig. 3 is a block diagram showing the principle of the present invention;
Fig. 4 is a block diagram of a structure of a tone signal generating part shown in Fig. 3;
Fig. 5 is a waveform diagram of operations of embodiments of the present invention;
Fig. 6 is a block diagram of a tone signal generating device according to a first embodiment of the present invention;
Fig. 7 is a block diagram of a coincidence detection circuit shown in Fig. 6;
Fig. 8 is a block diagram of a variation of the first embodiment of the present invention;
Fig. 9 is a block diagram of a tone signal generating device according to a second embodiment of the present invention;
Fig. 10 is a block diagram of a tone signal generating device according to a third embodiment of the present invention;
Fig. 11 is a block diagram of a tone signal generating device according to a fourth embodiment of the present invention;
Fig. 12 is a block diagram of a detailed structure of the tone signal generating device shown in Fig. 12; and
Fig. 13 is a block diagram of an electronic device equipped with the tone signal generating device of the present invention.

### DESCRIPTION OF THE PREFERRED EMBODIMENTS

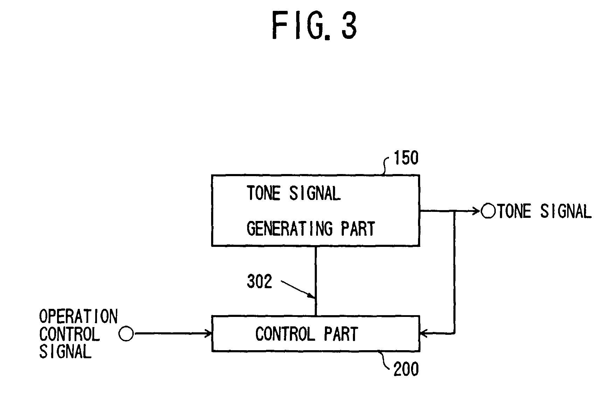

Fig. 3 is a block diagram showing the principle of a signal generating device according to the present invention. The signal generating device shown in Fig. 3 is a tone signal generating device which generates a tone signal. The tone signal generating device includes a tone signal generating part 150 and a control part 200. The tone signal generating part 150 generates a tone signal. The control part 200 controls the tone signal generating part 150 to generate the tone signal when an operation control signal is turned ON. The control part 200 inputs the tone signal (or a signal corresponding to the tone signal output by the tone signal generating part 150), and controls the tone signal generating part 150 by outputting an internal control signal 302 so that the tone signal is continuously output until the tone signal becomes equal to a given level.

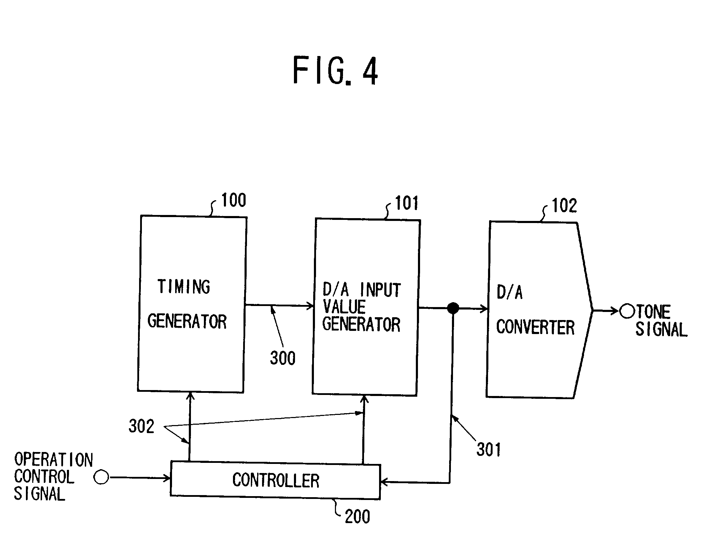

Fig. 4 is a block diagram of the detail of the tone signal generating device shown in Fig. 3, and particularly shows a detailed configuration of the tone signal generating part 150 . As shown in Fig. 4, the tone signal generating part 150 includes a timing generator 100, a D/A input value generator 101, and a D/A converter 102. The timing generator 100 is connected to the D/A input value generator 101, and outputs a data control signal 300, which causes it to generate a quantizing signal 301 applied to the D/A converter 102. The D/A input value generator 101 is connected to the D/A converter 102, and generates the quantizing signal 301 applied to the D/A converter 102 on the basis of the data control signal 300. The D/A converter 102 converts the quantizing signal 301 into a corresponding analog signal, which is output as a tone signal. The control part 200 receives the quantizing signal 301 output by the D/A input value generator 101, and compares it with a detecting condition value which corresponds to a voltage level obtained when the tone signal is not generated.

It should be noted that Fig. 3 is illustrated so that the tone signal is directly applied to the control part 200, while the quantizing signal 301 corresponding to the tone signal is applied to the control part 200 in Fig. 4. As will be described later, the signal applied to the control part 200 can be the tone signal or an arbitrary signal which corresponds to the tone signal, such as the above quantizing signal 301.

When the control part 200 receives the operation control signal from the outside of the tone signal generating device, it generates the internal control signal 302, which causes the timing generator 100 and the D/A converter 101. The control part 200 performs the above comparing operation, and controls the timing generator 100 and the D/A input value generator 101 so that the tone signal is continuously output (the internal control signal 302 continues to be output) until the result of the comparing operation indicates a coincidence.

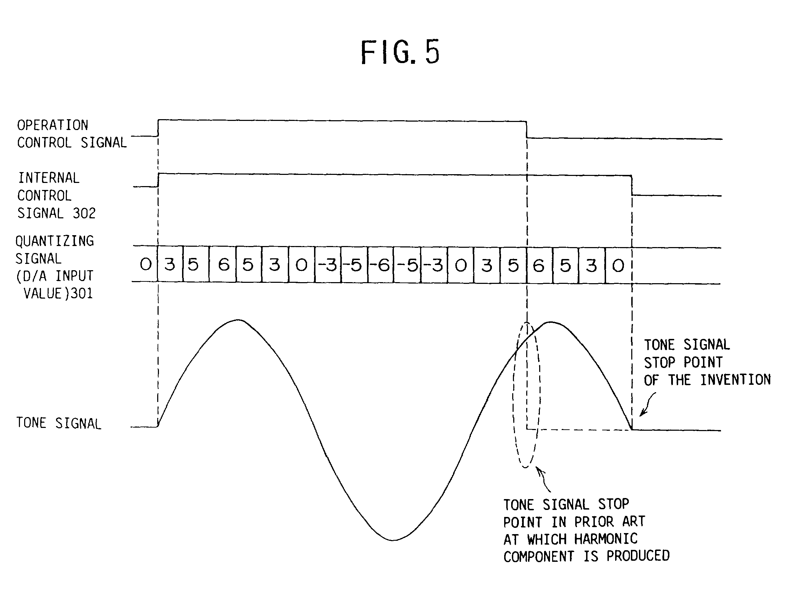

Fig. 5 is a timing chart showing the operation of the configuration shown in Fig. 4. When the operation control signal is turned ON (in other words, the operation control signal is switched to a high level), the internal control signal 302 is turned ON (switched to a high level), and the timing generator 100 and the D/A input value generator 101 start to operate. In the example shown in Fig. 5, the quantizing signal 301 applied to the D/A converter 102 is changed from "0" and assumes "3", "5", "6", ..., in this order. The D/A converter 102 converts the digital value indicated by the quantizing signal 301 into a corresponding analog value (voltage level), so that the tone signal having a waveform as shown in Fig. 5 can be generated.

The control part 200 uses the value "0" of the quantizing signal 301 as the detecting condition value, and compares the detecting condition value "0" with the value currently indicated by the quantizing signal 301. The detecting condition value "0" corresponds to a voltage level obtained when the tone signal is not generated (OFF). The above voltage level corresponds to the center of the peak-to-peak amplitude of the tone signal. The control part 200 makes a decision as to whether the current value of the quantizing signal 301 coincides with the detecting condition value "0". As long as the operation control signal is ON, the control part 200 continues to output the internal control signal 302 (maintains the signal 302 in the ON state) irrespective of the result of the above decision. The control part 200 turns OFF the internal control signal 302 when the current value of the quantizing signal 301 becomes equal to the detecting condition value "0" after the internal control signal is turned OFF.

In the example as shown in Fig. 5, the operation control signal is turned OFF when the quantizing signal 301 indicates "5". At that time, the tone signal is turned OFF in the prior art. Hence, noise is generated. On the other hand, the tone signal is continuously output until the value of the quantizing signal 301 becomes equal to the detecting condition value "0" even when the operation control signal is turned OFF. Hence, the disadvantage of the prior art can be overcome. As shown in Fig. 5, the tone signal does not have an abrupt level change and no noise is generated.

It should be noted that the description given with reference to Figs. 3 through 5 is intended to show the concept of the present invention such that the tone signal is continuously output until the given condition is satisfied even when the operation control signal is turned OFF. The above concept can be realized by various manners, as will be described below. It should be noted that the following block diagrams for realizing the concept of the present invention may slightly correspond to the block diagrams of Figs. 3, 4 and 5. For example, Fig. 3 is illustrated so that the control part 200 directly receives the tone signal, and Fig. 4 is illustrated so that the control part 200 directly receives the quantizing signal 301. The concept of the present invention can be realized by means other than the above. The internal control signal 302 functions as an enable signal in the above description. In an alternative, the internal control signal 302 can function as a disable signal.

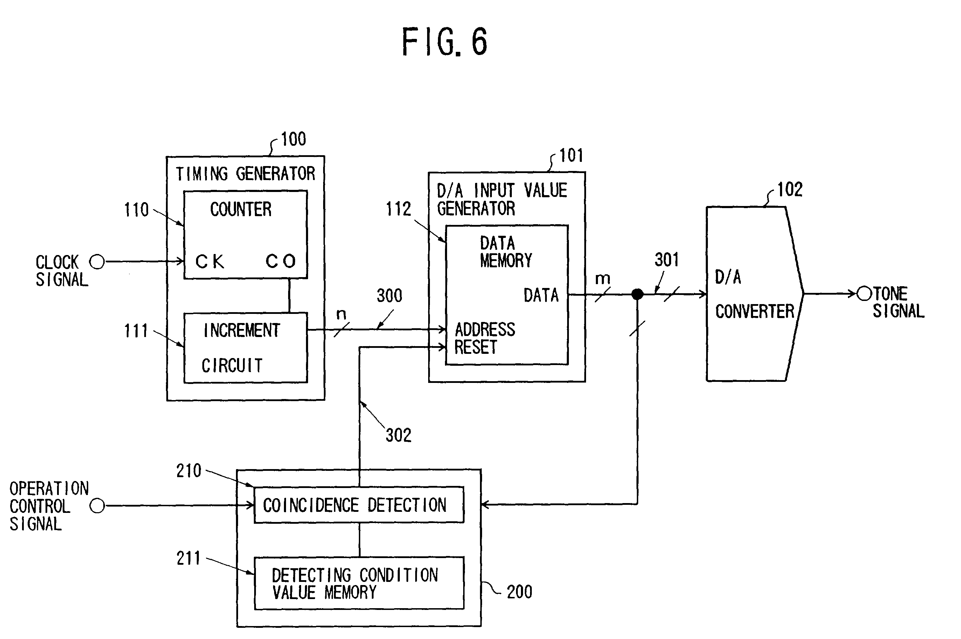

Fig. 6 is a block diagram of a tone signal generating device according to a first embodiment of the present invention. In Fig. 6, parts that are the same as those shown in Figs. 3 and 4 are given the same reference numbers.

The timing generator 100 is connected to the D/A input value generator 101 by an n-bit parallel signal line over which the data control signal 300 is transferred to the D/A input value generator 101 (n is an arbitrary integer). The output terminal of the D/A input value generator 101 is connected to the D/A converter 102 by an m-bit parallel signal line over which the quantizing signal 301 is transferred to the D/A converter 102 (m is an arbitrary integer). The m-bit parallel signal line branches in a part connected to the control part 200, which receives the output signal of the D/A input value generator 101.

The timing generator 100 has a counter 110 and an increment circuit 111. The counter 110 counts a clock signal supplied from the outside of the tone signal generating device shown in Fig. 6, and periodically produces a carry-out signal. The clock signal supplied from the outside of the tone signal generating device is, for example, a clock signal within the telephone set equipped with the present device and used to operate a CPU built therein. The carry-out signal which is periodically generated is applied to the increment circuit 111, which generates the data control signal 300 which consists of n bits and is changed at the timing when the carry-out signal is applied thereto. The data control signal 300 is applied to the D/A input value generating part 101.

The D/A input value generator 101 is connected to the timing generator 100 by the n-bit parallel signal line via which the data control signal 300 is transferred, and is connected to the D/A converter 102 and the control part 200 by the m-bit parallel signal line. The internal control signal 302 generated by the control part 200 is applied to the D/A input value generating part 101. The D/A input value generator 101 includes a data memory 112, which receives, as an address, the n-bit value indicated by the data control signal 300. Quantization information corresponding to the applied address is read from the data memory 112, and is applied, as the m-bit quantizing signal 301, to the D/A converter 102 and the control part 200. The D/A converter 102 converts the received quantizing signal 301 into a corresponding analog signal (a voltage level), which is the tone signal.

The control part 200 includes a coincidence detection circuit 210 and a detecting condition value memory 211. The memory 211 stores the detecting condition value, which is the digital value of the quantizing signal 301 corresponding to the voltage level of the output signal of the D/A converter 102 when the tone signal is not output. In the example shown in Fig. 5, the detecting condition value is "O". The coincidence detection circuit 210 compares the value indicated by the quantizing signal 301 with the detecting condition value, and generates a coincidence detection signal when the compared values coincide with each other. However, as long as the operation control signal is ON, the coincidence detection circuit 210 does not notify the D/A input value generator 101 of the detection of a coincidence. The coincidence detection circuit 210 outputs the internal control signal to the D/A input value generator when a coincidence is detected after the operation control signal is turned OFF.

The internal control signal 302 thus generated is applied to a reset input terminal of the data memory 112 of the D/A input value generator 101. When the internal control signal 302 is applied to the reset input terminal, the detecting condition value "0", which is the quantization information used at the time the tone signal is not generated, is output from the data memory 112. Hence, the quantization signal 301 having all the bits of zeros is output after the internal control signal 302 is applied to the reset terminal. Hence, voltage level of the tone signal obtained by converting the above quantization signal 301 is located at the center of the peak-to-peak amplitude.

As described above, the tone signal is not turned OFF immediately after the operation control signal is turned OFF, but the D/A converter 102 continues to operate until the voltage level of the tone signal becomes equal to the level of the center of the amplitude. Hence, it is possible to avoid occurrence of an abrupt level change of the tone signal and to generate the tone signal which has a waveform which gradually changes.

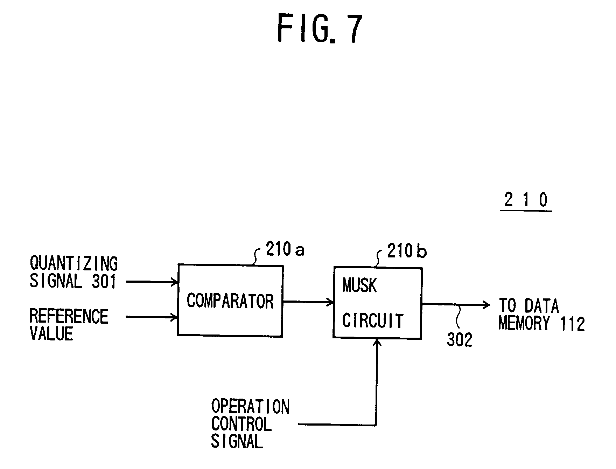

Fig. 7 is a block diagram of a structure of the coincidence detection circuit 210, which includes a comparator 210a and a mask circuit 210b. The comparator 210a inputs the detecting condition value and the quantizing signal 301, and produces an output signal when the two signals coincide with each other, that is, when the quantizing signal 301 indicates "0". The comparator 210a compares the digital signals, and thus can be formed by, for example, an exclusive-OR circuit. The mask circuit 210b inputs the output signal of the comparator 210a and the operation control signal. When the operation control signal changes from OFF to ON (changes from the low level to the high level), the mask circuit 210b changes its output signal from the low level to the high level, and masks the output signal of the comparator 210a, so that it is prevented from being output. When the operation control signal switches from ON to OFF, the mask circuit 210b releases the mask state, and allows the output signal to pass therethrough.

The above operation will be described with reference to Fig. 5. When the mask circuit 210b receives the operation control signal, it turns ON the internal control signal 302 (switches it to the high level). Hence, the reset state is released. The quantizing signal 301 having the digital value corresponding to the received data control signal 300 is read from the data memory 112. In the example shown in Fig. 5, the quantizing signal 301 indicates "0" twice during the time when the operation control signal is at the high level, and the coincidence detection signal is output by the comparator 210a twice. However, the mask circuit 210b masks the coincidence detection signal, and thus there is no change of the state of the internal control signal 302.

When the operation control signal is changed from the high level to the low level, the mask circuit 210b releases the mask state. In the example shown in Fig. 5, the quantizing signal 301 changes to "6", "5" and "3" after the operation control signal switches to the low level (OFF). During that time, the comparator 210a continues to output the high level. Hence, even when the operation control signal switches to the low level, the internal control signal 302 is maintained at the high level. Thereafter, the quantizing signal 301 indicates "0". At this time, the comparator 210a outputs the coincidence detection signal by changing its output signal from the high level to the low level. The coincidence detection signal passes through the mask circuit 210b, and is applied to the reset terminal of the data memory 112. Hence, the data memory 112 is caused to the reset state, and outputs the quantizing signal 301 indicating "0".

Thereafter, the quantizing signal 301 always indicates "0", and the comparator 210a outputs the low-level signal. The coincidence detection signal passes through the mask circuit 210b, and is applied to the reset terminal of the data memory 112.

In the structure shown in Fig. 6, the timing generator 100 is not controlled by the internal control signal 302, and thus continues to operate with the clock signal irrespective of whether the internal control signal 302 is ON or OFF. Hence, when the internal control signal 302 switches to ON (switches to the high level), the data control signal 300 output by the timing generator 100 may not become equal to the value corresponding to "O" of the quantizing signal 301. In this case, the quantizing signal 301 shown in Fig. 5 may not indicate "3" immediately after the internal control signal 302 is turned ON but may indicate a relatively large value such as "6". Such a large value causes the tone signal to rise rapidly.

When taking into consideration the above, it is preferable to control the timing generator 100 by the internal control signal 302.

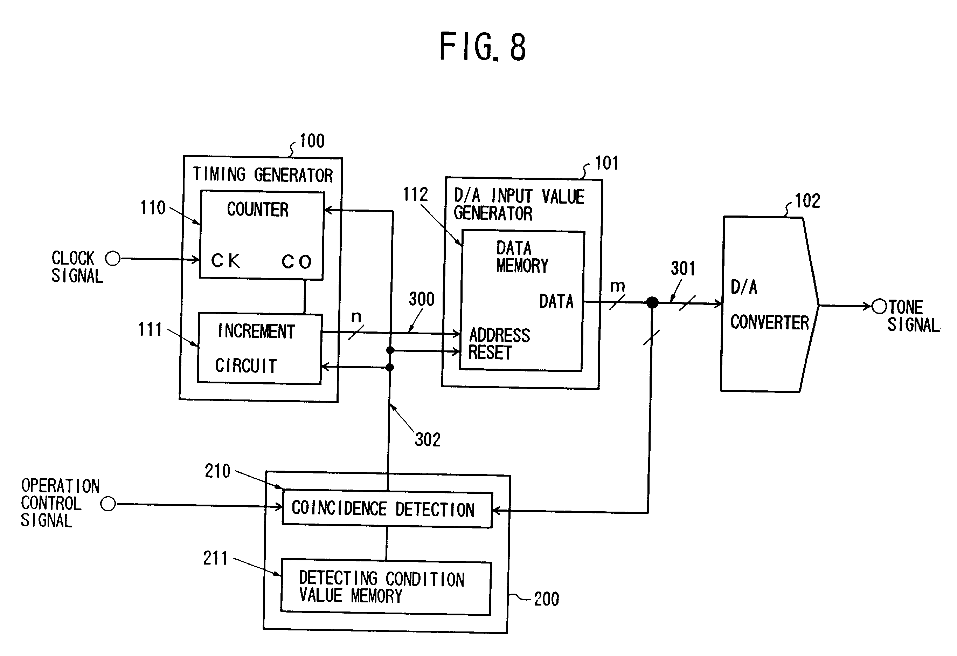

Fig. 8 is a block diagram of a tone signal generating device having an arrangement in which the timing generator 100 is controlled by the internal control signal 302. In Fig. 8, parts that are the same as those shown in Fig. 6 are given the same reference numbers. The internal control signal 302 output by the coincidence detection circuit 210 is applied to the counter 110 and the increment circuit 111, both of which are provided in the timing generator 100. During the time when the internal control signal 302 is at the low level, the counter 110 and the increment circuit 111 are maintained in the disabled state. Hence, the quantizing signal 301 can change from "0" when the operation control signal switches to ON from OFF. As a result, the above possibility can be avoided. In practice, there is no problem even if only the increment circuit 111 is made in the disabled state. In this case, the increment circuit 111 starts to output data control signal 300 at a slightly different timing although the counter 110 does not start from "0" when the operation control signal switches to ON.

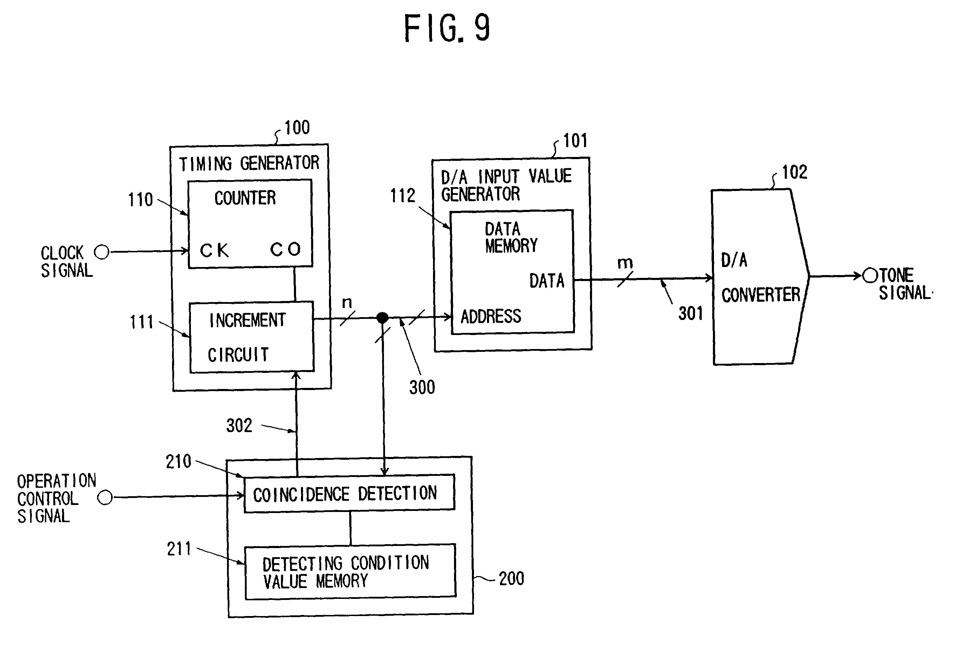

A description will now be given, with reference to Fig. 9, of a tone signal generating device according to a second embodiment of the present invention. In Fig. 9, parts that are the same as those shown in the previously described figures are given the same reference numbers.

In Fig. 9, the coincidence detection circuit 210 inputs the n-bit data control signal 300. When the tone signal is not output, the circuit 210 compares the n-bit data control signal 300 with the detecting condition value, which is a value indicated by the quantizing signal 301 corresponding to the voltage of the output signal of the D/A converter 102 when the tone signal is not generated. The internal control signal 302 output by the coincidence detection circuit 210 is applied to the increment circuit 111. The increment circuit 111 is maintained in the enabled state while the internal control signal 302 shown in Fig. 5 is at the high level. Hence, the tone signal generating device shown in Fig. 9 operates in the same manner as that of the tone signal generating device shown in Fig. 5.

The data memory 112 used in the configuration shown in Fig. 9 does not need the reset input terminal. The coincidence detection circuit shown in Fig. 9 can be configured as shown in Fig. 7.

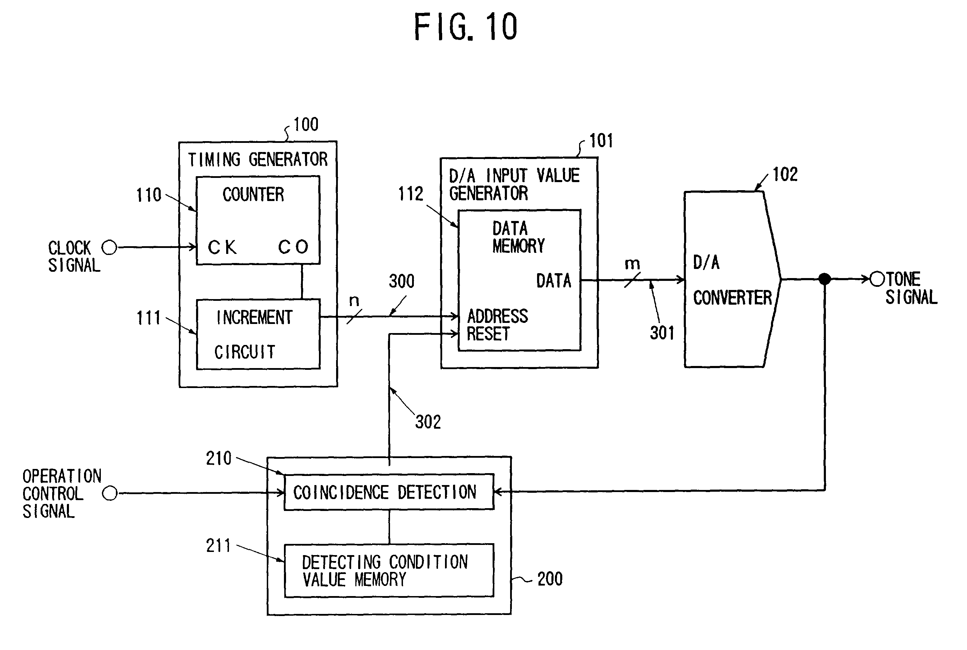

Fig. 10 is a block diagram of a tone signal generating device according to a third embodiment of the present invention. In Fig. 10, parts that are the same as those shown in the previously described figures are given the same reference numbers. The configuration shown in Fig. 10 differs from that shown in Fig. 6 in that the coincidence detection circuit 210 inputs the tone signal which is an analog signal. The block configuration of the coincidence detection circuit 210 shown in Fig. 10 is the same as that shown in Fig. 7. However, the comparator 210a shown in Fig. 7 is replaced by an operational amplifier or the like because the tone signal to be compared is an analog signal.

The tone signal generating devices configured according to the first through third embodiments of the present invention generate the tone signal having a single frequency component. In an alternative, the present invention includes a tone signal generating device capable of generating a tone signal including a plurality of frequency components.

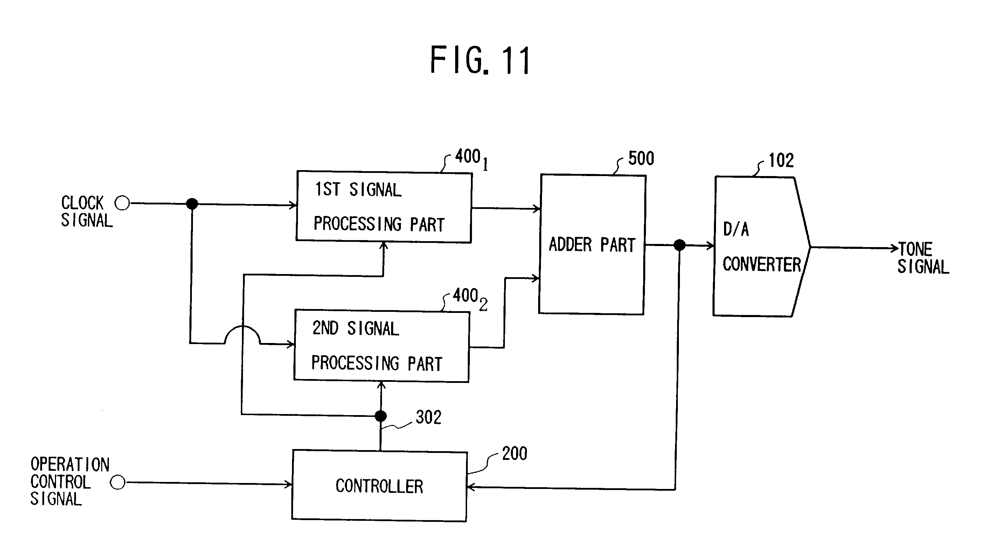

Fig. 11 is a block diagram of such a tone signal generating device according to a fourth embodiment of the present invention, which can generate a tone signal having two frequency components. The clock signal is applied to a first signal processing part 400₁ and a second signal processing part 400₂. Each of the first signal processing part 400₁ and the second signal processing part 400₂ includes a configuration which receives the clock signal and produces a quantizing signal. More particularly, each of the parts 400₁ and 400₂ includes the aforementioned timing generator 100 and the D/A input value generator 101.

The signal processing part 400₁ generates a quantizing signal, and the signal processing part 400₂ generates a quantizing signal relating to a frequency different from that related to the quantizing signal generated by the part 400₁. The quantizing signals respectively produced by the parts 400₁ and 400₂ are added in digital formation by an adder part 500. A resultant signal output by the adder part 500 is applied to the D/A converter 102 and the control part 200. The control part 200 operates in the same manner as the control parts 200 used in the first through third embodiments of the present invention, and outputs the internal control signal 302 to the parts 400₁ and 400₂.

With the above structure, it is possible to prevent the level of the tone signal having the combined frequency components from being rapidly changed when the tone signal is turned OFF and to generate the tone signal with little noise caused due to a harmonic component.

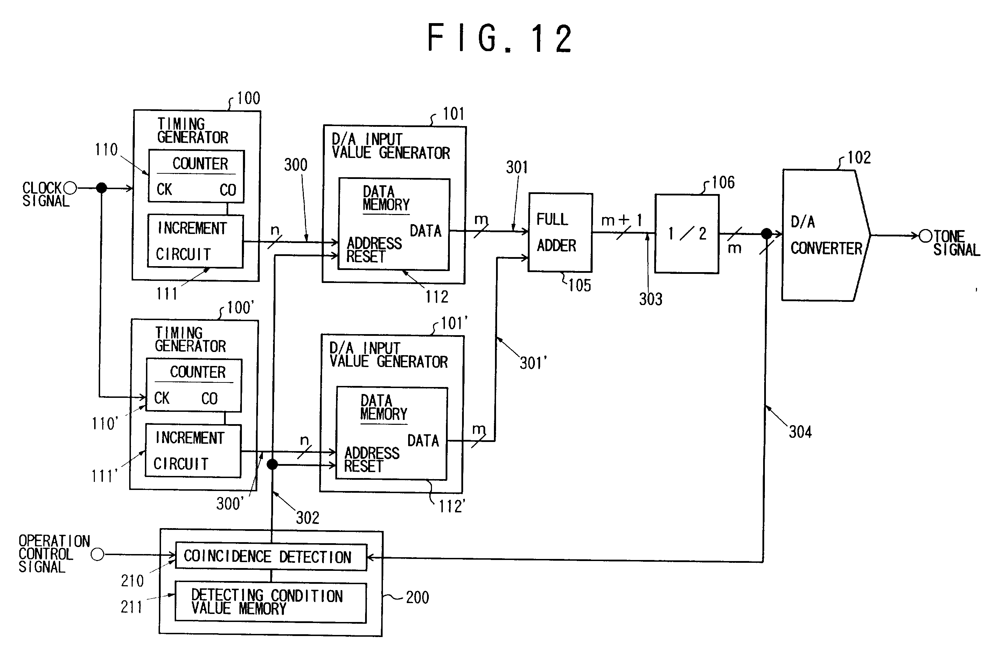

Fig. 12 is a block diagram of a detailed structure of the tone signal generating device shown in Fig. 11. In Fig. 12, parts that are the same as those shown in the previously described figures are given the same reference numbers.

The first signal processing part 400₁ is made up of the timing generator 100 and the D/A input value generator 101. The second signal processing part 400₂ is made up of a timing generator 100' and a D/A input value generator 101'. It should be noted that the reference numbers applied to the structural elements and signals of the second signal processing part 400₂ are given by adding a symbol "'" to the reference numbers given to the elements and signals of the first signal processing part 400₁. As shown in Fig. 12, the parts 400₁ and 400₂ have the same structure as each other. However, the relationship between the address of the data memory 112 and the corresponding quantizing signal 301 is different from the relationship between the address of the data memory 112' and the corresponding quantizing signal 301'. Further, the relationship between the carry-out signal of the increment circuit 111 and the corresponding data output signal 300 is different from the relationship between the carry-out signal of the increment circuit 111' and the corresponding data output signal 300'.

The adder part 500 shown in Fig. 11 is made up of a full adder 105 and a 1/2 divider 106. The full adder 105 adds the quantizing signals 301 and 301' in digital formation, and produces a resultant (m+1)-bit signal 303. The 1/2 divider 106 divides the (m+1)-bit signal 303 by two, and generates a resultant m-bit quantizing signal 304, which is applied to the D/A converter 102 and the control part 200. The control part 200 is configured as shown in Fig. 7, and operates in a manner as described previously. The internal control signal 302 output by the coincidence detection circuit 210 is applied the data memory 112 of the D/A input value generator 101 and the data memory 112' of the D/A input value generator 101'.

Alternatively, the control part 200 shown in Fig. 12 can be modified so that it compares the tone signal with the detecting condition value as in the case shown in Fig. 10.

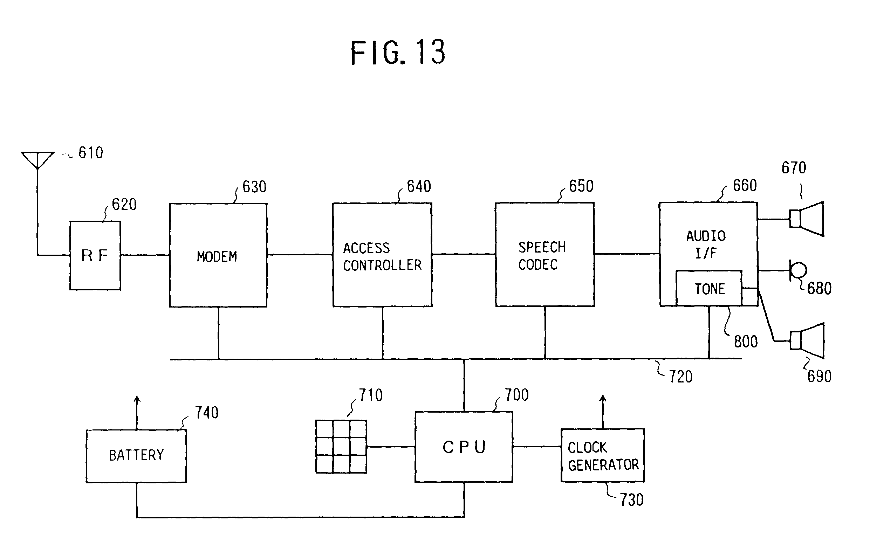

Fig. 13 is a block diagram of a portable telephone set equipped with the above-mentioned tone signal generating device. The portable telephone set shown in Fig. 13 includes an antenna 610, a high-frequency amplifier 620, a modem 630, an access controller 640, a speed codec 650, an audio interface (I/F) part 660, a speaker 670, a microphone 680, a speaker 690, a CPU 700, a key input part 710, a bus 720, a clock generator 730, and a battery 740. The audio interface part 660 includes a tone signal generating device 800 of the present invention. A clock signal necessary for the tone signal generating device 800 to generate the tone signal is generated by the clock generator 730. The operation control signal is generated by the CPU 700. The tone signal generated by the tone signal generating device 800 is applied to the speaker 690. The block configuration itself shown in Fig. 12 is the same as that of a conventional portable telephone set. Of course, the tone signal generating device 800 is configured according to the present invention.

When the portable telephone set receives a call, the high-frequency amplifier 620 amplifies the received signal. The modem 630 converts the amplified signal into a base-band signal. The access controller 640 determines that the portable telephone set is called when the received signal indicates the identification number (for example, a telephone number) of the portable telephone set. Then, the access controller 640 notifies the CPU 700 of receipt of the call directed to the portable telephone set. Then, the CPU 700 outputs the operation control signal to the tone signal generating device 800 (in other words, turns ON the operation control signal). When the operation control signal is turned ON, the tone signal generating device 800 starts to generate the tone signal, which is applied to the speaker 690 and is output as an acoustic signal.

When the operator or user pushes a given key in the key input part 710, the CPU 700 detects the above key operation, and turns OFF the operation control signal. As has been described previously, the tone signal generating device 800 continues to output the tone signal until the internal control signal is turned OFF after the operation control signal is turned OFF. Hence, the operator does not receive uncomfortable noise at all.

The tone signal can be generated when the user manipulates the key input part 710. The CPU 700 maintains the operation control signal in the ON state as long as the user is pushing a given key. When the user detaches a finger from the given key, the CPU 700 turns OFF the operation control signal. However, the tone signal is continuously output until the internal control signal is turned OFF. If the CPU 700 detects a shortage of the capacity of the battery 740, the CPU 700 produces a tone signal as an alarm. In this case, the CPU 700 intermittently turns ON and OFF the operation control signal during a given period so that a given acoustic pattern. Even in this case, the tone signal generating device 800 operates as described above, and hence the operator does not receive uncomfortable noise.

The detecting condition value memory 211 used in the above embodiments can be formed of a programmable non-volatile memory such as an electrically erasable and programmable ROM (EEPROM). In this case, it is possible to set the voltage level at which the tone signal should be stopped after the operation control signal is turned OFF to an arbitrary level. In this regard, the user can operate the key input part 710 and rewrite the detecting condition value stored in the EEPROM forming the memory 211 of the tone signal generating device 800 under control of the CPU 700.

In an alternative, a plurality of detecting condition values are stored in the memory 211, and the user selects a desired detecting condition value through the key input part 710. The above-mentioned EEPROM can be provided specifically to store the detecting condition values. If the CPU 700 includes a programmable non-volatile memory, it can be used to store the detecting condition values. If an analogous memory is coupled to the bus 720, it can be used to store the detecting condition values.

The present invention is not limited to the tone signal generating device, but includes a signal generating device which generates an analog signal by using the D/A converter. The present invention includes various electronic devices other than the portable telephone set. For example, the present invention includes a normal telephone set coupled to a switch office via a wiring line, or other electronic devices equipped with the D/A converter.

The present invention is not limited to the specifically disclosed embodiments, and variations and modifications may be made without departing from the scope of the present invention.

## Claims

1. A signal generating device comprising:
a first part which generates a given signal when an operation control signal applied thereto becomes active; and
a second part which causes the first part to continue to generate the given signal until the given signal becomes equal to a given level after the operation control signal becomes inactive.

2. A signal generating device comprising:
a signal processing part which generates a quantizing signal using a clock signal;
a D/A converter which converts the quantizing signal into an analog signal; and
a control part which controls the signal processing part to generate the quantizing signal when an operation control signal externally supplied is activated and to continue to generate the quantizing signal until the analog signal output by the D/A converter becomes equal to a given level after the operation control signal is made inactive.

3. The signal generating device as claimed in claim 2, wherein said control part comprises a coincidence detection part which compares the quantizing signal with a given detecting condition value and makes a decision as to whether the analog signal becomes equal to the given level.

4. The signal generating device as claimed in claim 2, wherein said signal processing part comprises:
a timing generator which counts the clock signal and thus produces a data control signal; and
a D/A input value generator which generates the quantizing signal based on the data control signal, and
wherein said control part comprises a coincidence detection part which compares the quantizing signal with a given detecting condition value and makes a decision as to whether the analog signal becomes equal to the given level.

5. The signal generating device as claimed in claim 2, wherein said control part comprises a coincidence detection part which compares the analog signal with a given detecting condition value and makes a decision as to whether the analog signal becomes equal to the given level.

6. The signal generating device as claimed in any of claims 2 through 5, wherein the analog signal comprises a single frequency component.

7. The signal generating device as claimed in any of claims 2 through 5, wherein the analog signal comprises a plurality of frequency components.

8. The signal generating device as claimed in any of claims 2 through 5, wherein said control part comprises a programmable part which stores the detecting condition value in a programmable formation.

9. An electronic device comprising:
a speaker which outputs an acoustic signal corresponding to a tone signal;
a part which generates an operation control signal; and
a signal generating device generating the tone signal,
said signal generating device comprising:
a first part which generates the tone signal when the operation control signal applied thereto becomes active; and
a second part which causes the first part to continue to generate the tone signal until the tone signal becomes equal to a given level after the operation control signal becomes inactive.

10. An electronic device comprising:
a speaker which outputs an acoustic signal corresponding to a tone signal;
a part which generates an operation control signal; and
a signal generating device generating the tone signal,
said signal generating device comprising:
a signal processing part which generates a quantizing signal using a clock signal;
a D/A converter which converts the quantizing signal into an analog signal which is the tone signal; and
a control part which controls the signal processing part to generate the quantizing signal when the operation control signal is activated and to continue to generate the quantizing signal until the analog signal output by the D/A converter becomes equal to a given level after the operation control signal is made inactive.
